# EUROPEAN PATENT APPLICATION

(11) **EP 3 852 140 A1**
(43) Date of publication of application: **21.07.2021**
(21) Application number: 20152638.1
(22) Date of filing: 20.01.2020
(51) Int. Cl.: H01L 23/488, H01L 21/60

(54) **SILICON CARBIDE POWER SEMICONDUCTOR DEVICE WITH A DIFFUSION SOLDERED JOINT COMPRISING NI3SN4 AND A CORRESPONDING FABRICATION METHOD**

(71) Applicant: Infineon Technologies Austria AG, 9500 Villach (AT)
(72) Inventor: OTREMBA, Ralf, 87600 Kaufbeuren (DE); HEINRICH, Alexander, 93077 Bad Abbach (DE); FRANK, Paul, 9500 Villach (AT); LUDSTECK-PECHLOFF, Alexandra, 82008 Unterhaching (DE); PEDONE, Daniel, 81739 Muenchen (DE); LANGER, Gregor, 9061 Klagenfurt (AT)
(74) Representative: Lambsdorff & Lange Patentanwälte Partnerschaft mbB

(57) **Abstract**

A SiC power semiconductor device (100, 200, 400) comprises: a power semiconductor die (110) comprising SiC and a metallization layer (111), wherein the metallization layer (111) comprises a first metal (e.g., Ni, Ag, Au, Pt), and a die carrier (120), wherein the power semiconductor die (110) is arranged over the die carrier (120) such that the metallization layer (111) faces the die carrier (120), the die carrier (120) being at least partially covered by a plating (140) that comprises Ni, and a first intermetallic compound (130) arranged between the power semiconductor die (110) and the plating (140) and comprising Ni ₃Sn ₄. The SiC power semiconductor device (200, 400) may further comprise precipitates of a second intermetallic compound (220) arranged within the first intermetallic compound (130), the second intermetallic compound (220) comprising a different material composition (e.g., Ag ₃Sn) than the first intermetallic compound (130). A method (500) for fabricating the SiC power semiconductor device (100, 200, 400) comprises: providing (501) the power semiconductor die (110) comprising SiC, depositing (502) the metallization layer (111) over the power semiconductor die (110), wherein the metallization layer (111) comprises the first metal, arranging (503) the power semiconductor die (110) over the die carrier (120) such that the metallization layer (111) faces the die carrier (120), the die carrier (120) being at least partially covered by the plating (140) that comprises Ni, and diffusion soldering (504) the power semiconductor die (110) to the die carrier (120), thereby forming the first intermetallic compound (130) between the power semiconductor die (110) and the plating (140), wherein the first intermetallic compound (130) comprises Ni ₃Sn ₄. The Ni ₃Sn ₄ is formed by reaction of Ni with Sn solder material layer (310). The Ag ₃Sn, if present, results from the presence of an Ag top layer (340) on the Sn solder material layer (310). The diffusion soldering may comprise pressing the power semiconductor die (110) onto the die carrier (120) with a pressure of 2N/mm ² or more. The diffusion soldering may comprise heating to a temperature of 250°C or more. The metallization layer (111), the solder material layer (310) and the top layer (340) may be deposited on a semiconductor wafer (410), followed by singulating (e.g., cutting along predetermined kerfs (420)) into individual power semiconductor dies (110).

## Description

### TECHNICAL FIELD

This disclosure relates in general to a SiC power semiconductor device and to a method for fabricating a SiC power semiconductor device.

### BACKGROUND

Power semiconductor devices comprising SiC (silicon carbide) as semiconductor material may exhibit several important advantages compared to power semiconductor devices comprising another semiconductor material like e.g. Si. A SiC power semiconductor device may comprise a SiC power semiconductor die that is mechanically and electrically connected to a die carrier. Such a connection may for example be achieved by diffusion soldering the SiC power semiconductor die to the die carrier. It may be desirable that the resulting solder joint provides a low electrical resistance and/or a low thermal resistance and/or a high mechanical stability. It may also be desirable that the resulting solder joint is resistant to crack propagation. Furthermore, semiconductor device manufactures constantly aim to improve manufacturing processes and reduce manufacturing costs. The solder materials and the process time required for creating a solder joint may contribute a significant percentage of the total fabrication costs of a power semiconductor device. Improved power semiconductor devices and improved method for fabricating power semiconductor devices may help with solving these and other problems.

The problem on which the invention is based is solved by the features of the independent claims. Further advantageous examples are described in the dependent claims.

### SUMMARY

Various aspects pertain to a SiC power semiconductor device, comprising: a power semiconductor die comprising SiC and a metallization layer, wherein the metallization layer comprises a first metal, a die carrier, wherein the power semiconductor die is arranged over the die carrier such that the metallization layer faces the die carrier, the die carrier being at least partially covered by a plating that comprises Ni, and a first intermetallic compound arranged between the power semiconductor die and the plating and comprising Ni₃Sn₄.

Various aspects pertain to a method for fabricating a SiC power semiconductor device, the method comprising: providing a power semiconductor die comprising SiC, depositing a metallization layer over the power semiconductor die, wherein the metallization layer comprises a first metal, arranging the power semiconductor die over a die carrier such that the metallization layer faces the die carrier, the die carrier being at least partially covered by a plating that comprises Ni, and diffusion soldering the power semiconductor die to the die carrier, thereby forming a first intermetallic compound between the power semiconductor die and the plating, wherein the first intermetallic compound comprises Ni₃Sn₄.

### BRIEF DESCRIPTION OF THE DRAWINGS

The accompanying drawings illustrate examples and together with the description serve to explain principles of the disclosure. Other examples and many of the intended advantages of the disclosure will be readily appreciated as they become better understood by reference to the following detailed description. The elements of the drawings are not necessarily to scale relative to each other. Identical reference numerals may designate corresponding similar parts.
Figure 1 is a sectional view of a power semiconductor device comprising a SiC semiconductor die diffusion soldered to a die carrier.
Figure 2 is a sectional view of a further power semiconductor device comprising a SiC semiconductor die, a first intermetallic compound and a second intermetallic compound.
Figure 3 is a sectional view of a precursor arrangement, wherein a SiC semiconductor die is arranged over a die carrier. By using a diffusion soldering process, the precursor arrangement may be converted into a power semiconductor device.
Figures 4A to 4F are sectional views of a further power semiconductor device in various stages of fabrication.
Figure 5 is a flow chart of a method for fabricating a power semiconductor device.

### DETAILED DESCRIPTION

In the following detailed description, reference is made to the accompanying drawings. It may be evident, however, to one skilled in the art that one or more aspects of the disclosure may be practiced with a lesser degree of the specific details. In other instances, known structures and elements are shown in schematic form in order to facilitate describing one or more aspects of the disclosure. In this regard, directional terminology, such as "top", "bottom", "left", "right", "upper", "lower" etc., is used with reference to the orientation of the Figure(s) being described.

The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "attached", or "connected" elements. However, it is also possible that the "bonded", "attached", or "connected" elements are in direct contact with each other. Also, the term "exemplary" is merely meant as an example, rather than the best or optimal.

The examples of a power semiconductor device described in the following may use various types of semiconductor dies or circuits incorporated in the semiconductor dies, among them AC/DC or DC/DC converter circuits, power MOS transistors, power Schottky diodes, JFETs (Junction Gate Field Effect Transistors), power bipolar transistors, logic integrated circuits, analogue integrated circuits, power integrated circuits, dies with integrated passives, etc.

The power semiconductor devices described below may include one or more power semiconductor dies. Furthermore, one or more logic integrated circuits may be included in the power semiconductor devices. The logic integrated circuits may be configured to control the integrated circuits of other semiconductor dies, for example the integrated circuits of the power semiconductor dies.

The notation XY may refer to an alloy of X including at least Y as a further component. In particular, it may refer to an alloy of X including Y as a sole residual component (i.e. a closed composition). That is, in the second case, the notation XY may mean that the alloy XY has a composition consisting of X (of the percentage in weight of X) and Y (of the percentage in weight of Y), the balance being only inevitable elements. The notation XYZ... may have an analogous meaning, i.e. an "open composition" or a "closed composition" with X, Y, Z, ... forming the sole constituents of the alloy (except inevitable elements). The same may apply to solder compositions.

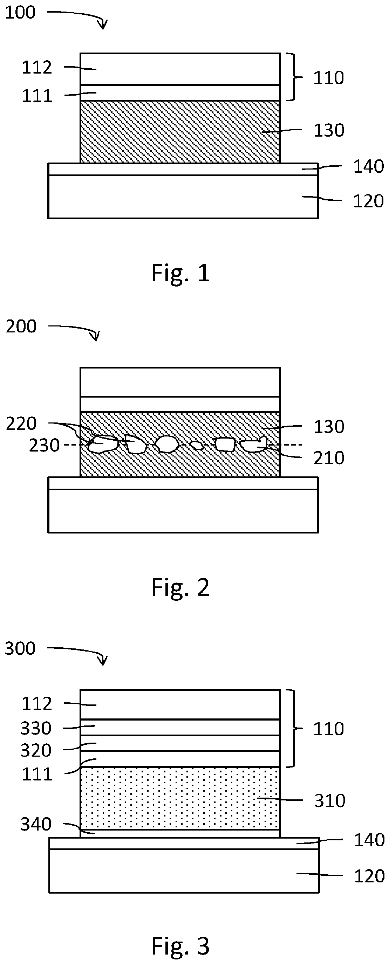

Figure 1 shows a SiC power semiconductor device 100 comprising a power semiconductor die 110, a die carrier 120 and a first intermetallic compound 130 arranged between the power semiconductor die 110 and the die carrier 120.

The power semiconductor die 110 comprises SiC as its semiconductor material. The power semiconductor die 110 may be configured to operate with a high voltage and/or a high electrical current. The power semiconductor die 110 may be configured to be operable at high temperatures, for example a temperature of 175°C or more, or a temperature of 200°C or more.

The power semiconductor die 110 may comprise a vertical transistor structure, wherein a first power electrode of the vertical transistor structure is arranged on a first main face facing the die carrier 110 and a second power electrode is arranged on an opposite second main face. The first power electrode may be electrically coupled to the die carrier 110 via the first intermetallic compound 130.

The power semiconductor die 110 may be thin. For example, the power semiconductor die 110 may have a thickness of 150µm or less, 100µm or less, or 50µm or less. During fabrication of the power semiconductor device 100 the power semiconductor die 110 may be coupled to a frame for mechanical support.

The power semiconductor die 110 comprises a metallization layer 111 comprising a first metal. The metallization layer 111 may be arranged on a SiC monocrystal 112. The metallization layer 111 may be arranged directly on the monocrystal 112 or one or more further metallization layers may be arranged between the metallization layer 111 and the monocrystal 112. The metallization layer 111 may completely cover the first main face of the power semiconductor die 110 or it may cover the first main face only partially.

The first metal comprised in the metallization layer 111 may for example be Ni, Ag, Au, or Pt. The metallization layer 111 may solely consist of the first metal or it may comprise the first metal and one or more further metals. The metallization layer 111 may e.g. comprise or consist of NiV.

The metallization layer 111 may have any suitable thickness (the thickness being measured perpendicular to the first main face of the power semiconductor die 110). The metallization layer 111 may e.g. have a thickness in the range of 50nm to 700nm. For example, the metallization layer 111 may comprise or consist of NiV and have a thickness of about 500nm. The V content of the metallization layer 111 may e.g. be 10wt% or less, or 5wt% or less.

According to another example, the metallization layer 111 may comprise or consist of Ag, Au, or Pt and may have a thickness of about 50nm to about 100nm.

The die carrier 120 may be electrically conductive and it may be electrically coupled to the power semiconductor die 110. The die carrier 120 may e.g. be a leadframe, a direct copper bond (DCB) substrate, a direct aluminum bond (DAB) substrate, or an active metal brazing (AMB) substrate. The die carrier 120 may e.g. comprise or consist of Cu.

The die carrier 120 is at least partially covered by a plating 140. In particular, a surface of the die carrier 120 facing the power semiconductor die 110 may be partially or completely covered by the plating 140. The plating 140 may e.g. be fabricated via an electroplating technique or any other suitable deposition technique. The plating 140 may comprise Ni. The plating 140 may also consist of Ni. According to another example, the plating 140 may comprise or consist of NiP, or NiPd, or NiPdAu, or NiPdAuAg. The P content or the Pd content and/or the Au content and/or the Ag content of the plating 140 may e.g. be 10wt% or less, or 5wt% or less. The Ni content of the plating may e.g. be 90wt% or more. A plating 140 consisting of NiP, or NiPd, or NiPdAu, or NiPdAuAg may be more resistant to oxidation than a plating 140 consisting of pure Ni.

According to an example, the plating 140 may for example have a thickness of 2µm or less, or 1.6µm or less, or 1µm or less. The plating 140 may be thinner than the die carrier 120, in particular much thinner than the die carrier 120.

The first intermetallic compound 130 is arranged between the power semiconductor die 110 and the plating 140. The first intermetallic compound 130 may be arranged directly on the metallization layer 111. However, it is also possible that one or more further metal layers are arranged between the metallization layer 111 and the first intermetallic compound 130.

The first intermetallic compound 130 may be arranged directly on the plating 140. However, it is also possible that one or more further metal layers are arranged between the plating 140 and the first intermetallic compound 130.

The first intermetallic compound 130 may be the product of a diffusion soldering process performed during fabrication of the power semiconductor device 100. Such a diffusion soldering process may comprise a Sn layer arranged on the metallization layer 111 reacting with the metallization layer 111 (e.g. with Ni of the metallization layer 111) and with the plating 140 (e.g. with Ni of the plating 140).

The first intermetallic compound 130 comprises or consists of Ni₃Sn₄. The first intermetallic compound 130 may have any suitable thickness. For example, the first intermetallic compound 130 may have a thickness of 2µm or less, or 1.6µm or less, or 1.2µm or less, or 1µm or less. The thickness of the precursor Sn layer may be chosen such that no unreacted Sn remains after diffusion soldering.

According to an example, the first intermetallic compound 130 may comprise first intermetallic growth structures pointing from the metallization layer 111 towards the plating 140 and second intermetallic growth structures pointing from the plating 140 towards the metallization layer 111.

Figure 2 shows a further power semiconductor device 200 which may be similar or identical to the power semiconductor device 100, except for the differences described in the following.

The power semiconductor device 200 comprises the first intermetallic compound 130 and also a second intermetallic compound 210. The second intermetallic compound 210 may have a material composition that is different from the material composition of the first intermetallic compound 130.

The second intermetallic compound 210 may for example be arranged within the bulk of the first intermetallic compound. The second intermetallic compound 210 may also be arranged between the first intermetallic compound 130 and the plating 140 or between the first intermetallic compound 130 and the metallization layer 111.

According to an example, the second intermetallic compound 210 forms precipitates 220 that are arranged within the first intermetallic compound 130. The precipitates 220 may be disjointed inclusions within the first intermetallic compound 130. The precipitates 220 may e.g. have a diameter that amounts to 60% or less of the thickness of the first intermetallic compound 130.

According to an example, the precipitates 220 are essentially arranged in a plane 230 (i.e. the center of each or the center of most or the center of a large number of precipitates 220 may be arranged within the plane 230). The plane 230 may for example be arranged halfway between the metallization layer 111 and the plating 140. It is however also possible that the plane 230 is arranged closer to the metallization layer 111 or closer to the plating 140.

According to an example, the second intermetallic compound 210 comprises Ag. The second intermetallic compound may for example comprise or consists of Ag₃Sn.

Figure 3 shows a precursor arrangement 300 of the power semiconductor device 100 or 200 prior to diffusion soldering the power semiconductor die 110 onto the die carrier 120, according to an example.

The precursor arrangement 300 comprises the power semiconductor die 110 with metallization layer 111 and the die carrier 120 with the plating 140. The precursor arrangement 300 further comprises a solder material layer 310 arranged between the metallization layer 111 and the plating 140. The solder material layer 310 comprises a metal that is capable of forming intermetallic phases with a metal of the metallization layer 111 and a metal of the plating 140. The solder material layer 310 may e.g. comprise a metal with a comparatively low melting point and the metallization layer 111 and plating 140 may each comprise a metal with a comparatively high melting point. For example, the solder material layer 310 may comprise or consist of Sn and the metallization layer 111 and the plating 140 may each comprise Ni. The first intermetallic compound 130 may be the product of the solder material layer 310 reacting with the metallization layer 111 and the plating 140.

According to an example, the solder material layer 310 essentially consists of Sn. In particular, the solder material layer 310 does not comprise AuSn as solder material. Using Sn instead of e.g. AuSn as solder material may be more cost efficient.

The solder material layer 310 may for example have a thickness of 2µm or less, or 1.6µm or less, or 1.2µm or less, or 1µm or less.

The precursor arrangement 300 may optionally comprise a first additional metallization layer 320 arranged between the metallization layer 111 and the SiC monocrystal 112. The first additional metallization layer 320 may e.g. comprise or consist of Ti. The first additional metallization layer 320 may e.g. have a thickness of about 100nm.

The precursor arrangement 300 may optionally comprise a second additional metallization layer 330 arranged between the first additional metallization layer 320 and the SiC monocrystal 112. The second additional metallization layer 330 may e.g. comprise or consist of NiSi or CuSi. The second additional metallization layer 330 may e.g. have a thickness of about 40nm.

The precursor arrangement 300 may optionally comprise a top layer 340 arranged on the solder material layer 310. The top layer 340 may be configured as an oxidation prevention layer that prevents oxidation of the solder material layer 310. The top layer 340 may comprise a metal that is capable of forming intermetallic phases with a metal of the solder material layer 310. The second intermetallic compound 210 (see Fig. 2) may be the product of the top layer 340 reacting with the solder material layer 310 during a diffusion soldering process.

The top layer 340 may comprise or consist of Ag. According to another example, the top layer 340 comprises or consists of Au. The top layer 340 may have a thickness of about 50nm, about 100nm, or about 20nm.

The power semiconductor die 110 may be arranged on the die carrier 120 such that the top layer 340 touches the plating 140.

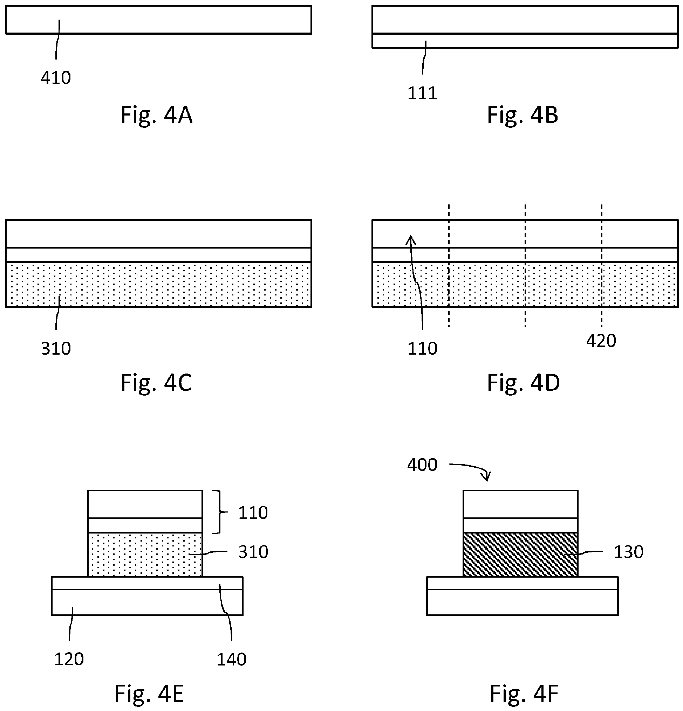

Figures 4A to 4F show a power semiconductor device 400 in various stages of fabrication, according to an example of a method for fabricating a power semiconductor device. The power semiconductor device 400 may be similar or identical to the power semiconductor devices 100 and 200.

As shown in Figure 4A, a semiconductor wafer 410 is provided. The semiconductor wafer 410 comprises or consists of SiC. The semiconductor wafer 410 may be thin. For example, a backside grinding process or any other suitable process may have been used to thin the semiconductor wafer 410. One side of the semiconductor wafer, e.g. the upper side in Fig. 4A, may be attached to a mechanical support, e.g. a tape or frame.

As shown in Figure 4B, the metallization layer 111 is deposited on the semiconductor wafer 410, e.g. by using a sputtering process or any other suitable deposition technique. According to an example, the first additional metallization layer 320 and/or the second additional metallization layer 330 are deposited on the semiconductor wafer prior to depositing the metallization layer 111 (not shown in Fig. 4B) .

As shown in Figure 4C, the solder material layer 310 is deposited on the metallization layer 111. Depositing the solder material layer 310 may e.g. comprise dispensing solder material onto the metallization layer 111 or it may comprise depositing a solder preform on the metallization layer 111. According to an example, the solder material may comprise a fluxing agent and e.g. heat may be applied to the deposited solder material to remove the fluxing agent. According to an example, the top layer 340 is deposited on the solder material layer 310 (not shown in Fig. 4C). Depositing the top layer 340 may e.g. comprise sputtering or any other suitable deposition technique.

As shown in Figure 4D, the semiconductor wafer 410 is singulated into individual power semiconductor dies 110. Singulating may comprise cutting the semiconductor wafer 410 along predefined kerfs 420.

As shown in Figure 4E, a singulated power semiconductor die 110 is arranged on the die carrier 120 such that the solder material layer 310 faces the plating 140. Arranging the power semiconductor die 110 on the die carrier 120 may comprise using a pick-and-place process.

As shown in Figure 4F, the power semiconductor die 110 is diffusion soldered to the die carrier 120, thereby forming the first intermetallic compound 130. According to an example, diffusion soldering also comprises forming the second intermetallic compound 210, as e.g. shown in Fig. 2 (the second intermetallic compound 210 may e.g. be formed in case that the top layer 340 was deposited on the solder material layer 310).

The diffusion soldering may comprise applying a high temperature (e.g. 250°C or more, or 300°C or more, or 350°C or more, or 400°C or more) and/or a high pressure (e.g. 2N/mm² or more, or 4N/mm² or more, or 6N/mm² or more) onto the power semiconductor die 110 and the die carrier 120. Since the power semiconductor die 110 comprises SiC and since SiC has a higher mechanical robustness than e.g. Si, it is possible to press the power semiconductor die 110 onto the die carrier 120 with a greater force than it would be possible with e.g. a power semiconductor die comprising Si. Exerting a higher pressure may e.g. result in a reduction of the necessary process time and/or the necessary process temperature of the diffusion soldering process.

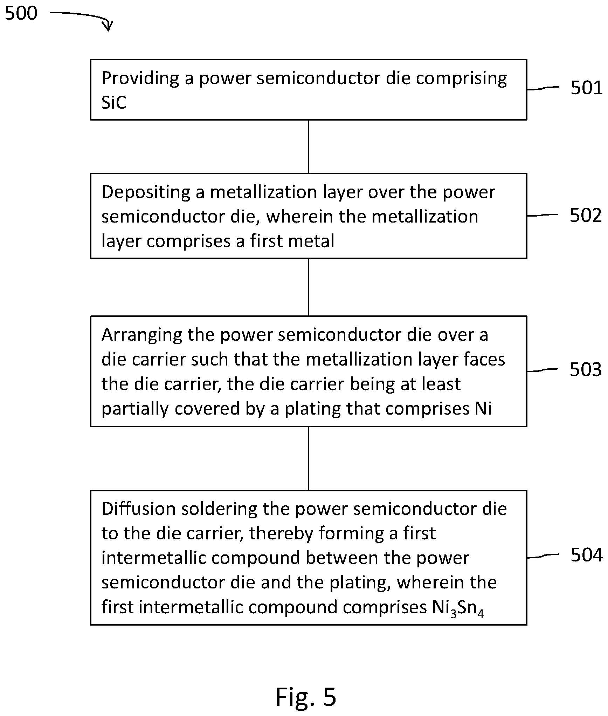

Figure 5 is a flow chart showing a method 500 for fabricating a power semiconductor device. The method 500 may e.g. be used to fabricate the power semiconductor device 100, 200 or 400.

The method 500 comprises at 501 an act of providing a power semiconductor die comprising SiC, at 502 an act of depositing a metallization layer over the power semiconductor die, wherein the metallization layer comprises a first metal, at 503 an act of arranging the power semiconductor die over a die carrier such that the metallization layer faces the die carrier, the die carrier being at least partially covered by a plating that comprises Ni, and at 504 an act of diffusion soldering the power semiconductor die to the die carrier, thereby forming a first intermetallic compound between the power semiconductor die and the plating, wherein the first intermetallic compound comprises Ni₃Sn₄.

According to an example of the method 500, the diffusion soldering optionally comprises pressing the power semiconductor die onto the die carrier with a pressure of 2N/mm² or more, or 4N/mm² or more, or 6N/mm² or more. According to another example of the method 500, the diffusion soldering may additionally or alternatively comprise the application of heat of 250°C or more, 300°C or more, 350°C or more, 400°C or more, or about 500°C.

The diffusion soldering of act 504 may optionally comprise forming precipitates comprising a second intermetallic compound during the diffusion soldering, wherein the second intermetallic compound comprises Ag₃Sn.

### EXAMPLES

In the following, the power semiconductor device and the method for fabricating a power semiconductor device are further described using specific examples.
Example 1 is a SiC power semiconductor device, comprising: a power semiconductor die comprising SiC and a metallization layer, wherein the metallization layer comprises a first metal, a die carrier, wherein the power semiconductor die is arranged over the die carrier such that the metallization layer faces the die carrier, the die carrier being at least partially covered by a plating that comprises Ni, and a first intermetallic compound arranged between the power semiconductor die and the plating and comprising Ni₃Sn₄.
Example 2 is the SiC power semiconductor device of example 1, wherein the first metal is Ni, Ag, Au, or Pt.
Example 3 is the SiC power semiconductor device of example 1 or example 2, further comprising: precipitates of a second intermetallic compound arranged within the first intermetallic compound, the second intermetallic compound comprising a different material composition than the first intermetallic compound.
Example 4 is the SiC power semiconductor device of example 3, wherein the second intermetallic compound comprises Ag₃Sn.
Example 5 is the SiC power semiconductor device of example 3 or example 4, wherein the precipitates are essentially arranged in a plane parallel to the die carrier.
Example 6 is the SiC power semiconductor device of one of examples 3 to 5, wherein the precipitates are essentially arranged halfway between the metallization layer and the plating.
Example 7 is the SiC power semiconductor device of one of the preceding examples, wherein the plating comprises NiP, or NiPd, or NiPdAu, or NiPdAuAg.
Example 8 is the SiC power semiconductor device of one of the preceding examples, wherein the first intermetallic compound has a thickness in the range of 1µm to 2µm.
Example 9 is the SiC power semiconductor device of one of the preceding examples, wherein the die carrier comprises a leadframe, a DCB, a DAB, or an AMB.
Example 10 is the SiC power semiconductor device of one of the preceding examples, wherein the power semiconductor die comprises a vertical transistor structure, wherein a power electrode of the vertical transistor structure is electrically coupled to the die carrier via the first intermetallic compound.
Example 11 is the SiC power semiconductor device of one of the preceding examples, wherein the power semiconductor die has a thickness of 150µm or less.
Example 12 is a method for fabricating a SiC power semiconductor device, the method comprising: providing a power semiconductor die comprising SiC, depositing a metallization layer over the power semiconductor die, wherein the metallization layer comprises a first metal, arranging the power semiconductor die over a die carrier such that the metallization layer faces the die carrier, the die carrier being at least partially covered by a plating that comprises Ni, and diffusion soldering the power semiconductor die to the die carrier, thereby forming a first intermetallic compound between the power semiconductor die and the plating, wherein the first intermetallic compound comprises Ni₃Sn₄.
Example 13 is the method of example 12, wherein the diffusion soldering comprises: pressing the power semiconductor die onto the die carrier with a pressure of 2N/mm² or more.
Example 14 is the method of example 12 or example 13, wherein the diffusion soldering comprises: applying heat of 250°C or more.
Example 15 is the method of one of examples 12 to 14, further comprising: depositing a Ag layer over the power semiconductor die, and forming precipitates comprising a second intermetallic compound during the diffusion soldering, wherein the second intermetallic compound comprises Ag₃Sn.
Example 16 is an apparatus comprising means configured to perform the method of one of examples 12 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A SiC power semiconductor device, comprising:
a power semiconductor die comprising SiC and a metallization layer, wherein the metallization layer comprises a first metal,
a die carrier, wherein the power semiconductor die is arranged over the die carrier such that the metallization layer faces the die carrier, the die carrier being at least partially covered by a plating that comprises Ni, and
a first intermetallic compound arranged between the power semiconductor die and the plating and comprising Ni₃Sn₄.

2. The SiC power semiconductor device of claim 1, wherein the first metal is Ni, Ag, Au, or Pt.

3. The SiC power semiconductor device of claim 1 or claim 2, further comprising:
precipitates of a second intermetallic compound arranged within the first intermetallic compound, the second intermetallic compound comprising a different material composition than the first intermetallic compound.

4. The SiC power semiconductor device of claim 3, wherein the second intermetallic compound comprises Ag₃Sn.

5. The SiC power semiconductor device of claim 3 or claim 4, wherein the precipitates are essentially arranged in a plane parallel to the die carrier.

6. The SiC power semiconductor device of one of claims 3 to 5, wherein the precipitates are essentially arranged halfway between the metallization layer and the plating.

7. The SiC power semiconductor device of one of the preceding claims, wherein the plating comprises NiP, or NiPd, or NiPdAu, or NiPdAuAg.

8. The SiC power semiconductor device of one of the preceding claims, wherein the first intermetallic compound has a thickness in the range of 1µm to 2µm.

9. The SiC power semiconductor device of one of the preceding claims, wherein the die carrier comprises a leadframe, a DCB, a DAB, or an AMB.

10. The SiC power semiconductor device of one of the preceding claims, wherein the power semiconductor die comprises a vertical transistor structure, wherein a power electrode of the vertical transistor structure is electrically coupled to the die carrier via the first intermetallic compound.

11. The SiC power semiconductor device of one of the preceding claims, wherein the power semiconductor die has a thickness of 150µm or less.

12. A method for fabricating a SiC power semiconductor device, the method comprising:
providing a power semiconductor die comprising SiC,
depositing a metallization layer over the power semiconductor die, wherein the metallization layer comprises a first metal,
arranging the power semiconductor die over a die carrier such that the metallization layer faces the die carrier, the die carrier being at least partially covered by a plating that comprises Ni, and
diffusion soldering the power semiconductor die to the die carrier, thereby forming a first intermetallic compound between the power semiconductor die and the plating, wherein the first intermetallic compound comprises Ni₃Sn₄.

13. The method of claim 12, wherein the diffusion soldering comprises:
pressing the power semiconductor die onto the die carrier with a pressure of 2N/mm² or more.

14. The method of claim 12 or claim 13, wherein the diffusion soldering comprises:
applying heat of 250°C or more.

15. The method of one of claims 12 to 14, further comprising:
depositing a Ag layer over the power semiconductor die, and
forming precipitates comprising a second intermetallic compound during the diffusion soldering, wherein the second intermetallic compound comprises Ag₃Sn.
